(19) Europäisches Patentamt
European Patent Office
Office européen des brevets

(11) Publication number : **0 378 728 B1**

(12) **EUROPEAN PATENT SPECIFICATION**

(45) Date of publication of patent specification :
04.10.95 Bulletin 95/40

(51) Int. Cl.⁶ : **G01T 1/00**, G01T 1/24

(21) Application number : 89100958.1

(22) Date of filing : 20.01.89

(54) **X ray detecting device.**

(43) Date of publication of application :
25.07.90 Bulletin 90/30

(45) Publication of the grant of the patent :
04.10.95 Bulletin 95/40

(84) Designated Contracting States :
DE FR GB

(56) References cited :
EP-A- 0 316 222
US-A- 4 243 885
JAPANESE JOURNAL OF APPLIED PHYSICS, vol.
24, no. 8, part 1, August 1985, pages 1105-1106,
Tokyo, JP; W. GUANG-PU et al: "Amorphous-silicon
photovoltaic X-ray sensor"
Idem

(73) Proprietor : Kanegafuchi Chemical Industry Co., Ltd.
2-4 Nakanoshima 3-chome
Kita-ku Osaka-shi Osaka-fu (JP)

(72) Inventor : Nakayama, Takehisa
2-9-30, Maikodai
Tarumi-ku
Kobe-shi Hyogo-ken (JP)

Inventor : Hayashi, Akimine
8-16-20-628, Shimoyamatedoori
Chuo-ku
Kobe-shi Hyogo-ken (JP)
Inventor : Kondo, Masataka
159-3, Kamikemadote
Amagasaki-shi Hyogo-ken (JP)
Inventor : Murakami, Satoru
6-6-522, Maikodai
Tarumi-ku
Kobe-shi Hyogo-ken (JP)
Inventor : Yamaguchi, Minori
5-40, Higashihitomaru-cho
Akashi-shi Hyogo-ken (JP)
Inventor : Tawada, Yoshihisa
14-39, Ooikemiyamadai
Kita-ku
Kobe-shi Hyogo-ken (JP)
Inventor : Hosomi, Masahiko
6-31-17, Shioya-cho
Tarumi-ku
Kobe-shi Hyogo-ken (JP)

(74) Representative : Lehn, Werner, Dipl.-Ing. et al
Hoffmann, Eitle & Partner,
Patentanwälte,
Postfach 81 04 20
D-81904 München (DE)

# Description

## BACKGROUND OF THE INVENTION

### FIELD OF THE INVENTION

The present invention relates to an X ray detecting device using semiconductor device.

### DESCRIPTION OF THE PRIOR ART

In a roentgen diagonal device for taking a radioscopy picture of a patient, there is used an X-ray detecting device for measuring the intensity of the X-ray to control the intensity of the X ray radiation from an X-ray source. The X ray detecting device mentioned above is usually disposed between the X ray source and the patient.

There have been proposed such an X-ray detecting device comprising an X ray to light converting unit (referred to XL converter) for converting the incident X ray into visible light and a light to electric converting unit (LE converter) for converting the visible light into an electric signal, so that the intensity of the X ray can be measured by the electric signal. In the conventional X ray detecting device of the above type, the LE converter is formed using a base plate made of glass or metal plate. the X ray passing the X ray detecting device is attenuated by the base plate made of glass plate or metal plate, whereby the amount of the X ray to be radiated on the patient becomes shortage and an unnecessary image of the base plate of the LE converter appears on the radiography of the patient and therefore a clear patient's radiography can not be obtained. In order to prevent the appearance of the image of the base pate of the LE converter on the radiography in the conventional device, it is necessary to use a large X ray detecting device having a large LE converter which is larger than the object to be radiographed. In order to accomplish this purpose, if there is provided a large X ray detecting device, it is unreasonable to use the large size X ray converter having a large size LE converter to radiograph a relatively small sized object. In addition the large size LE converter causes the weight of the X ray detection device to be heavy and the operability of the X ray detection device becomes deteriorated.

The article in the Japanese Journal of Applied Physics, vol. 27, no. 8, part 1, August 1985, pages 1105-1106, by W. Guang-Pu et al, entitled "Amorphous Silicon Photovaic X-Ray Sensor" describes an X-ray sensor including a glass base plate with phosphor coating on one side and a transparent electrode on the other, a semiconductor p-i-n junction and a final electrode.

EP-A-0 316 222 describes a device for producing a radiological image. The device has a glass base plate, a series of smaller photoelectric converting means and a scintillator.

## SUMMARY OF THE INVENTION

An essential object of the present invention is to provide an X ray detecting device in which attenuation of the X ray is small so that a sufficient amount of the X ray can reach to the object to be radiographed.

Another object of the present invention is to provide an X ray detecting device which is able to provide a clear radiography of an object without forming the image of the X ray detecting device in the picture even if the size of the X ray detecting device is smaller than the size of the object.

A further object of the present invention is to provide a X ray detecting device provided with a circuit arrangement which is able to generate an electric signal of enough high voltage even if the output of the X ray sensor is low.

According to the present invention there is provided an X-ray detecting device for placement between an X-ray source and a radiographic recording means, and which comprises XL-converting means for receiving and transmitting X-rays and radiating visible light, the intensity of which light corresponds to the intensity of the received X-rays; and LE-converting means for receiving the light generated from said XL-converting means and generating an electrical signal corresponding to the intensity of the of the visible light, said LE-converting means comprising electrode means for deriving the electric signal and a base layer; characterised in that said LE-converting means further comprises an amorphous semiconductor photo electric converting layer, and said base layer is made of polyimide film having a thickness of 25 μm to 150 μm so that no image of the X-ray detecting device is produced on the radiographic recording means placed to receive the X-rays.

Fig. 1 is a side view of an embodiment of a X ray detecting device according to the present invention,

Figs. 2 and 3 are respectively plan views showing various examples of the X ray detecting device according to the present invention,

Fig. 4 is a cross sectional view showing another embodiment of the X ray detecting device according to the present invention,

Fig. 5 is a plan view showing an embodiment of the X ray detecting device with lead conductors according to the present invention,

Fig. 6 is a plan view showing a LE converter used in the embodiment shown in Fig. 5,

Fig. 7 is a cross sectional view taken along the lines A-A in Fig. 5,

Fig. 8 is a cross sectional view taken along the lines B-B in Fig. 5,

Fig. 9 is a circuit diagram of one example of the X ray detecting device according to the present invention,

Fig. 10 is an example of the X ray detecting device used with the circuit shown in Fig. 9,

Fig. 11 is a graph showing an operation of the circuit shown in Fig. 9,

Fig. 12 is a circuit diagram showing another example of the circuit for use with the X ray detecting device,

Fig. 13 is a graph showing an operation of the circuit shown in Fig. 12,

Fig. 14 is a circuit diagram showing a further example of the circuit for use with the X ray detecting device,

Figs. 15 and 16 are graphs showing operation of the circuit shown in Fig. 14,

Fig. 17 is a circuit diagram showing a further example of the circuit for use with the X ray detecting device,

Fig. 18 is a graph showing an operation of the circuit shown in Fig. 17, and

Figs. 19 to 24 are cross sectional view showing various examples of a cassette film incorporating the X ray detecting device.

## DETAILED DESCRIPTION OF THE PREFERRED EMBODIMENTS

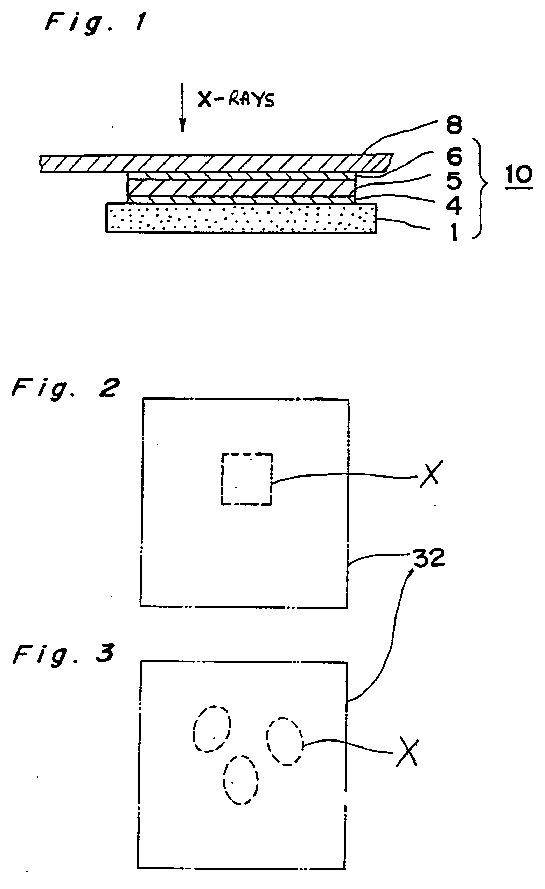

Referring to Fig. 1, there is shown a substrate 1 of a rectangular shape made of X ray permeable and mechanically strong material such as polyimide film of a uniform thickness. The thickness of the substrate 1 may be selected between 25 μm to 150 μm. A metal electrode 4 of 1,000 angstrome thick is formed on the top surface of the substrate 1. The metal electrode 4 is made of $A\ell$, Cr or Ag and has a shape similar to that of the substrate but is somewhat smaller than the substrate 1. A LE converting layer 5 of a p-i-n type semiconductor material using amorphous silicon for converting light to electrical (referred to as LE hereinafter) signal is formed on the top surface of the metal electrode 4 with 10,000 angstrom thick. A transparent electrical conducting layer 6 made of indium titan oxide (ITO) material, $Sn\,O_2$ or ZnO is formed on the top surface of the LE converting layer 5 so as fully to cover the layer 5. The assembly by the components 1,4,5 and 6 provides a light to electrical converting unit 10.

A X ray to light converting layer (XL converting layer) 8 is formed on the conducting layer 6 having an area greater than the LE converting unit 10 is formed on the top surface of the electrical conducting layer 6.

All of the members mentioned above are made by X ray permeable material so that the X ray can pass the device shown in Fig. 1 with few X ray absorption.

In the arrangement shown in Fig. 1, when X ray is projected onto XL converting unit 8, the X ray projected on the XL converting unit 8 is converted to visible light, which is radiated to the LE converting layer 5 passing through the electrical conducting layer 6. The light radiated onto the LE converting unit 10 causes the LE converting unit 10 to generate a voltage between the metal electrode 4 and transparent electrode 6. Therefore, it is possible to measure the amount of the intensity of the X ray by measuring the voltage between the transparent electrode layer 6 and the metal electrode 4.

In order to taking a picture of a patient using the X ray detecting device mentioned above, the X ray detecting device is disposed in the range of the X ray radiation between the patient and the X ray generating device. In the X ray detecting device of the above embodiment uses the polyimide film as the substrate 1 of the LE converting unit 10, the X ray can pass the LE converting unit with few absorption of the X ray, the image of the LE converting unit does not appear in the radiography. Accordingly, it is not necessary to provide a LE converting unit having almost the same size of the object as used in the prior art. For example, when the X ray detecting device of the present invention is used, the size of the LE converting unit is small size as depicted in the dotted lines in Fig. 2 which is smaller than the size of the object X to be radiographed shown in the chain lines in Fig. 2. Since the image of the LE converting unit does not appear on the picture of the X ray radiography, it is possible to place the X ray detecting device according to the present invention anywhere desired and further it is possible to use various configuration of the device as shown in dotted lines in Fig. 3.

However, since the XL converting unit 8 may absorb the X ray more or less for converting the X ray to visible light, there may appear the image of the XL converting unit on a radiography picture, it is necessary to make the XL converting unit larger or the same size of the area to be radiographed. This means that the LE converting unit is smaller than the XL converting unit in the plan geometrical shape.

It is noted that the $A\ell$ equivalent of the LE converting unit is made desirably less than 1 mm and preferably less than 0.5 mm.

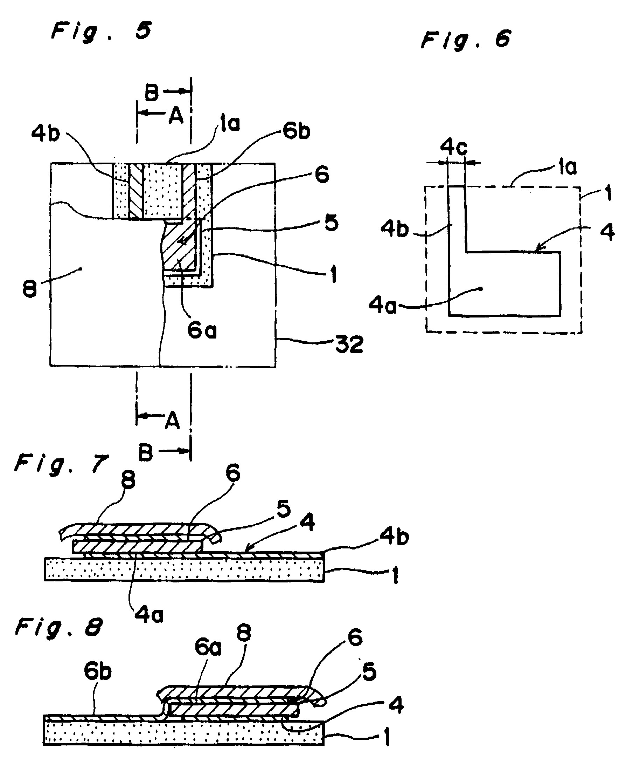

Referring to Fig. 4, there is shown a substrate 3 of a rectangular shape made of X ray permeable material such as composite material of carbon fibers and epoxy resin with 350 mm square wide and 0.4 mm thick. A thin shielding film 2 made of aluminum is formed on the surface of the substrate 3 with about 17 μm for reflecting light generated in a XL converting unit 8 the details of which will be described later and for shielding external electrical noise.

A base film 1 made of polyimide film is formed on a central portion of the $A\ell$ thin film 2 of 125 μm thick and 125 mm square wide. A lower electrode 4 of 1,000 angstroms is formed on the top surface of the base film 1 made of $A\ell/Cr$ by way of vacuum deposition technique with the same area of the base film 1. A LE converting layer 5 of a p-i-n type semiconductor material using amorphous silicon for converting light to electrical signal is formed on the top surface of the lower electrode 4 with 10,000 angstrom thick by way of a glow discharge method. A transparent electrical conducting layer 6 made of indium titan oxide (ITO) material is formed on the top surface of the LE converting layer 5 so as fully to cover the layer 5. The components 1, 4, 5 and 6 provide a light to electrical converting unit 20 and is secured on the central portion of the $A\ell$ thin film 2 by adhesive agent. The LE converting unit 20 is fully covered by a sealing film 7a made of light permeable, moisture proof and adhesive material with about 0.2 mm thick so that the LE converting unit 20 is fully sealed from the outside atmosphere. The sealing film is made of for example ethylene vinyl acetate material.

A X ray to light converting layer (XL converting layer) 8 is formed on the sealing film 7a with an area similar to the area of the substrate 3 so as to fully cover the upper surface of the LE converting unit 20. The XL converting unit 8 is made by coating fluorescent member of $Cd_2O_2S : Tb$ material on a transparent paper or plastic resin film. A further sealing film 7b made of light permeable, moisture proof and adhesive material is formed on the XL converting layer 8 and a Tedler film 9 (fluorine resin with $A\ell$ inserted material) is formed on the further sealing film 7b so that they are formed in parallel with the top surface of the LE converting layer 5 or the surface of the substrate 3.

It is desired that the base film 1 made of polyimide film is in a range of 25 μm to 150 μm thick.

In the arrangement shown in Fig. 4, when the X ray is projected onto the bottom surface of the substrate 3 which is the surface opposite to the $A\ell$ thin film 2, the X ray can pass the device shown in Fig. 4 from the substrate 3 to the Tedler film 9 passing the substrate 3, $A\ell$ thin film 2, LE converting unit 20, sealing films 7a and 7b and XL converting unit 8 with few absorption of the X ray. The X ray projected on the XL converting unit 8 is converted to visible light, which is radiated to the LE converting layer 5 passing both of the sealing films 7a and 7b. The light radiated toward the Tedler film 9 is reflected by the $A\ell$ film in the Tedler film 9 and directed to the LE converting unit 20, while the light which is not directly projected onto the LE converting unit 20 is reflected by the $A\ell$ film 2 reaching the LE converting unit 20, then the light is converted into an electric signal. In the manner as mentioned above, the LE converting unit 20 generates a voltage proportional to the intensity of the X ray and voltage can be generated across the transparent electrode layer 6 and the lower electrode 4, so that it is possible to measure the amount of the intensity of the X ray by measuring the voltage between the transparent electrode layer 6 and the lower electrode 4.

In the embodiment mentioned above, the lower electrode 4 is made of $A\ell$/Cr, in place of the above material, there may be used $A\ell$, Ag, Cr, $A\ell$/Ag alloy or Cr/Ag alloy. As the transparent, moisture proof and adhesive material for the sealing films 7a and 7b, polyvinylbutyral (PVB) may be used in place of EVA. The XL converting unit 8 may be formed of $CaWO_4$, BaF $C\ell$: Eu may be used. The further sealing film 7b may be formed between the substrate 3 and shielding film 2 or may be formed between the substrate 3 and $A\ell$ light thin film 2 and or the $A\ell$ thin film 2 and the polyimide base film 2 or between the $A\ell$. film 2 and the polyimide film layer 1.

As mentioned above, since the X ray detecting device in the above embodiment is formed to pass the X ray without attenuation of the X ray using a mechanical strong material such as carbon fiber including material as the substrate 3, the X ray detecting device can be formed thin and light assuring a similar mechanical strength of the conventional device. In addition, by sealing the LE converting unit with the transparent, moisture proof bonding material so as to prevent to contact with the ambient atmosphere, it is possible to prevent deterioration of the function of the device due to the absorption of the humidity, whereby the life of the X ray detecting device can be extended. Also it is possible to decrease the noise of the X ray detecting device by sealing the LE converting unit by the $A\ell$ thin film, so that error of the X ray detecting device can be decreased.

It is noted that as the base plate 3, there may be used various other X ray permeable material such as plastic resin layer or SUS (staniless steel sheet) or glass plate which are sufficiently thin to pass the X ray.

Referring to Figs. 5 to 8, the substrate 1 made of a polyimide film of 50 μm thick has an area smaller than the area 32 (shown by chain lines in Fig. 5) to be radiographed. The lower electrode 4 made of $A\ell$ of 50 to 10,000 angstrom thick is formed on the substrate 1. With the thickness of the lower electrode 4 mentioned above, the work is easy and X ray is permeable in addition, the resistance of the lead is low. The plan view of the lower electrode 4 has a rectangular main portion 4a on which the LE converting unit is placed and a lead conductor 4b extending from one edge of the main portion 4a to one side 1a of the substrate 1 with a narrow width 4c. The lead conductor 4b is made of the same material as that of the main portion 4a. The LE converting layer 5 made of amorphous silicon of p-i-n type semiconductor active layer is formed on the main portion 4a of the lower electrode 4 with a uniform thickness of 1 μm. The transparent electrode 6 made of $SnO_2$ is formed on the top surface of the LE converting layer 5 with 1,000 angstrom thick. The main portion 6a of the transparent electrode 6 extends toward the side 1a by means of an elongated conductor 6b on the top surface of the substrate 1 in parallel with but electrically insulated from the lead conductor 4b. The size of the main portion 6a and conductor 6b of the transparent electrode 6 is almost the same as that of the main portion 4a and lead conductor 4b of the lower electrode 4. The main portions 4a and 6a of the respective electrodes 4 and 6 substantially oriented in the vertical relation. The conductors 4b and 6b may be 500 to 10,000angstrom thick.

In the embodiment shown, although the lead conductor 6b is formed integral with the main portion 6a, they may be separately manufactured and connected after they are fabricated and placed on the positions shown. Also, it is possible to make the main portion 4a and the lead conductor 4b separately, thereafter they can be connected. It is also possible to make the main portion 4a or 6a and conductor 4b or 6b of the lower electrode 4 or transparent electrode 6 by different materials. In order to allow to pass the light, it is desired that the electrode 6 is thinner. However, the thinner the electrode, the higher the resistance of the electrode as the lead conductor becomes. From this point of view it is desired to use $A\ell$ thin film as the conductor 6b. The XL converting unit 8 made of ZnS is formed on the transparent electrode 6. The XL converting unit 8 has an area similar to the area to be radiographed.

The arrangement mentioned above is positioned in such a manner that the side 1a of the substrate 1 is oriented with the side of the area to be radiographed or the side 1a is outside of the radiographed area but the main portion 4a is inside the radiographed area.

Under such a condition, when the X ray is radiated onto the XL converting unit 8, the X ray is converted into visible light, which reaches the LE converting layer 5 through the transparent electrode 6. The LE converting layer 5 generates voltage corresponding to the intensity of the X ray across the lower electrode 4 and transparent elector 6. The voltage generated across the electrodes 4 and 6 are derived from the conductors 4b and 6b. In the embodiment shown in Figs. 5 to 8, since the ends of the conductors 4b and 6b can be placed out of the area to be radiographed, undesired image of connections at the conductors 4b and 6b such as the image of the solders for connecting the external wires and conductors 4b and 6b does not appear in the picture of the radiograph.

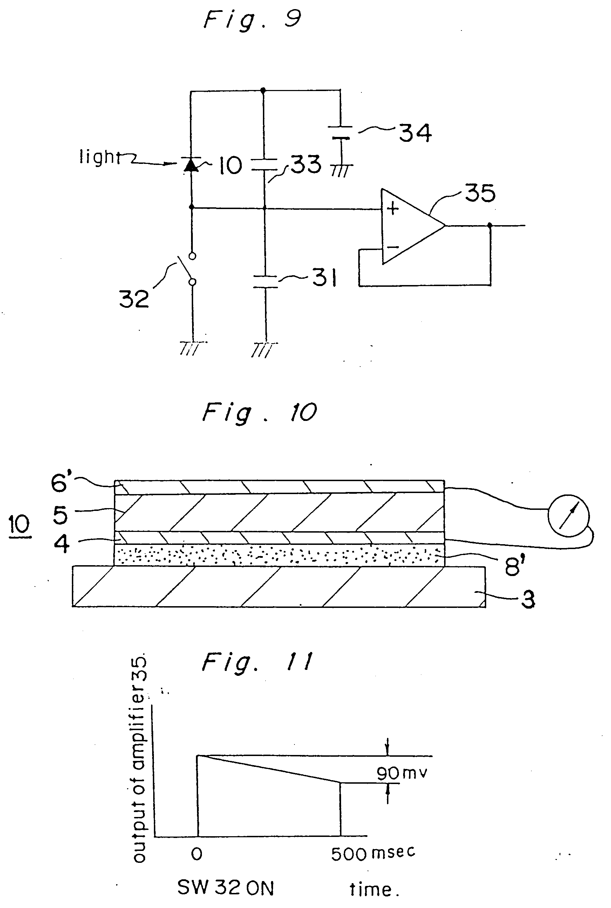

Fig. 9 shows an example of a light measurement circuit for the X-ray detecting device as shown in the embodiments mentioned above. The circuit arrangement shown in Fig. 9 may be connected to the various X-ray detecting device mentioned already. However, in the embodiment, explanation is made in the case where the circuit arrangement is connected with another X-ray detecting device shown in Fig. 10 in which the LE converter unit 10 or 20 is placed on the substrate 3 through a XL converting layer 8'. The substrate 3 has an Aluminium equivalent smaller than lmm and preferably smaller than 0.5 mm.

The XL converting layer 8' is a fluorescent layer made of mixture in which fluorescent material such as CaWO$_4$ or Gd$_2$0$_2$S : Tb is mixed in heat hardenable resin of phoenol epoxy resin system. The transparent electrode film or lower electrode 4 made of In$_2$0$_3$ is formed on the XL converting unit 8' by way of the vacuum deposition. The LE converting layer 5 formed on the lower electrode 4 is a p-i-n semiconductor diode made of amorphous silicon of 6,000 angstrom thick. Formed on the LE converting layer 5 is an upper electrode 6' made of A or Cr with 1,000 angstrom thick. The size of the substrate of the device shown in Fig. 10 is about 45 cm x 45 cm.

In the device shown in Fig. 10, the incident X-ray reaches the XL converting unit 8' through the LE converting unit 10 and the X-ray is converted into visible light therein and the visible light is converted into an electrical signal in the LE converting unit 10 and voltage corresponding to the intensity of the X ray can be obtained across the electrodes 4 and 6'. The LE converting layer 5 includes a plurality of hetero junction layers, one of which is made of amorphous silicon carbide containing III or V atoms. The mixture rate of the carbon in the amorphous silicon carbide is less than 0.60 and more than 0.05 against the silicon atoms. The LE converting layer 5 is a diode made of p type semiconductor of amorphous silicon carbide, i type semiconductor of amorphous silicon and n type semiconductor amorphous silicon, so that a high light to electric conversion efficiency can be obtained.

Referring to Fig. 9, the diode 10 formed by the electrodes 4 and 6' and the LE converting layer 5 has its anode connected to the ground through a capacitor 31 and a manually operable switch 32 for shortcircuiting the capacitor 31. The anode of the diode 10 is further connected to the non inverted input terminal + of an operational amplifier 35 for converting the current to voltage. A capacitor 33 connected to the diode 10 shows an equivalent capacitor or stray capacitor of the diode 10. The cathode of the diode 10 is connected to the negative terminal of a D.C. power source 34 having its positive terminal grounded.

In the circuit arrangement mentioned above, after the switch 32 is turned on for a given period to shortcircuiting the capacitor 31, the switch 32 is turned off. When no X ray is radiated onto the X ray detecting device, the output voltage Voo of the amplifier 35 is

$$Voo = E \times C1 /(C1 + C2),$$

wherein E is the voltage of the power source, C1 and C2 are capacitances of the respective capacitors 33 and 31. When the current flows the capacitor 31 upon receipt of the X ray, the current i is integrated by the capacitor 31 and the integrated value is amplified by the amplifier 35, the output voltage Vo1 of which is expressed as

$$Vo - 1/C \int i \times dt$$

wherein C is C1/(C1 + C2).

In the conventional X ray detecting circuit, since the capacitance of the LE converting unit is large, there has occurred noise and the response of the amplifier has been slow. For example, in the conventional X ray detecting circuit, as the amplifier 13nV/VHz is used with R = 330 KΩ and C = 1.1 μF, noise of 10 mV p-p has been generated. However, according to the present embodiment shown in Fig. 9, noise can be decreased to -40 dB from the noise of the prior art detecting device.

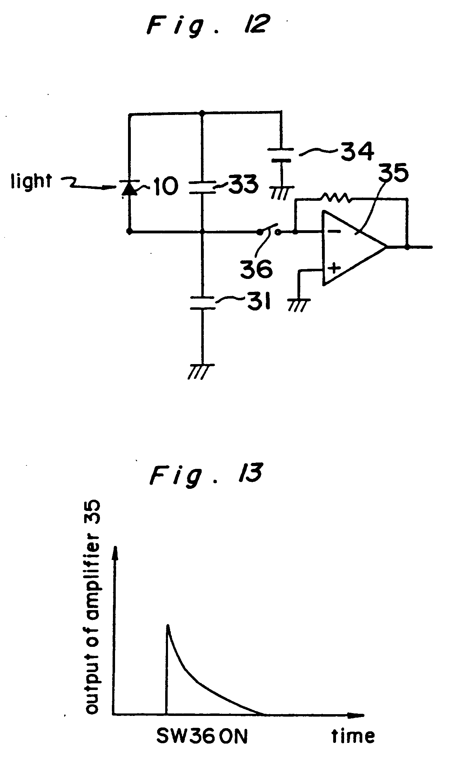

In the example test of the present embodiment, the capacitance C2 of the capacitor 31 was 100 pF and the diode 10 was 80 mm² a-Si pin diode structure with E = 2V. As the amplifier 35, a low bias voltage and low drift type having FET input stage was used. Using the diode 10 which could generate 0. 2 μA of small output, 90 millivolts could be obtained from the amplifier 35 when the switch was turned off after 500 milliseconds from the turn on of the switch 12 as shown in Fig. 11. Thus it is apparent that the amplifier according to the present invention can sufficiently amplify the very low output value of the X ray detecting device.

Fig. 12 shows another example of the X ray detection circuit in which the switch 36 is connected between the anode of the diode 10 and the input terminal of the amplifier 35. The switch 32 in Fig. 9 is omitted. When the switch 36 is turned on, the charge stored in the capacitor 31 is converted to the voltage, being amplified by the amplifier 35. The output voltage is shown in Fig. 13. According to the embodiments of the X ray detecting circuit shown in Figs. 9 and 12, there can be obtained a high speed and low noise detecting circuit since the charge of the capacitor 31 serially connected to the diode 10 of the X ray detecting device can be directly measured.

Referring to Fig. 14 showing a further example of the X ray detecting circuit, the diode 10 has its anode and cathode connected to input terminals of amplifiers 41 and 42 the output of which are connected to amplifiers 43 and 44 through resistors 55 and 56 respectively. A parallel circuit of a capacitor 51 and a resistor 52 for determining the response speed is connected between the output terminal and input terminal of the amplifier 41. A parallel circuit of a capacitor 541 and a resistor 53 for determining the response speed is connected between the output terminal and input terminal of the amplifier 42. A parallel circuit of a capacitor 58 and a manually operable switch 57 is connected between the input and output of the amplifier 43. A parallel circuit of a capacitor 60 and a manually operable switch 59 is connected between the input and output of the amplifier 43. The output terminals of the amplifiers 43 and 44 are connected to a switch 61 operable by the output signal of a comparator 62 which compares the output of the amplifier 41 and a reference voltage E.

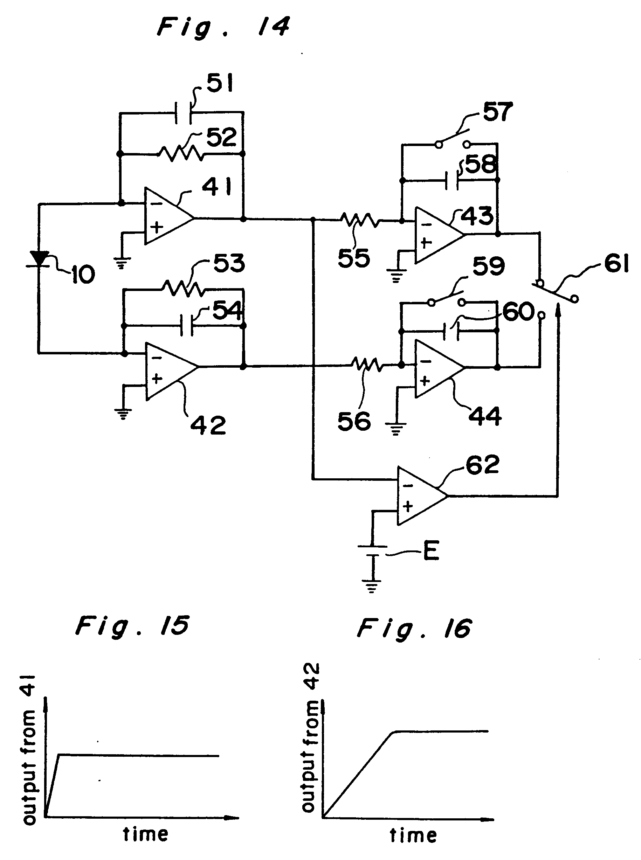

It is noted that the response speed of the amplifier 41 is faster than that of amplifier 42 as shown in Figs. 15 and 16 and the gain of the amplifier 42 is higher than that of the amplifier 41. It is assumed that the resistance of the resistors 52, 53, 55 and 56 are expressed as R52, R53, R55 and R56 and the capacitance of the capacitors 58 and 60 are expressed as C58 and C60. It is further assumed the resistance R52 = R53, C58 = C60. If R52 is not equal to R53, R52/R55 x C 58 = R53/R56 x C60. When the X ray detecting device shown in Fig. 10 receives X ray, the output of the diode 10 is applied to the amplifiers 41 and 42 and amplified therein. When the output voltage of the amplifier 41 is higher than the level of the reference voltage E, that is the level of the X ray is high, the comparator 62 causes the switch 61 to be switched toward the amplifier 43, so as to amplify the output of the diode 10 with a high response speed and low gain.

In the reversed case, that is the intensity of the X ray is low and the output of the amplifier 41 is lower than the reference voltage E, the switch 61 is switched to the amplifier 44, so that the low level output of the diode 10 is amplified by the high gain amplifiers 42 and 44 with relatively low response speed with low noise, whereby it is possible to amplify the low output of the X ray signal under a good S/N ratio and an accurate detection of the X ray can be made.

As mentioned above, since two amplifying systems of high gain low response speed and low gain of high response speed can be switched automatically corresponding to the output level of the X ray detecting device, it is possible to detect the X ray over a wide level range.

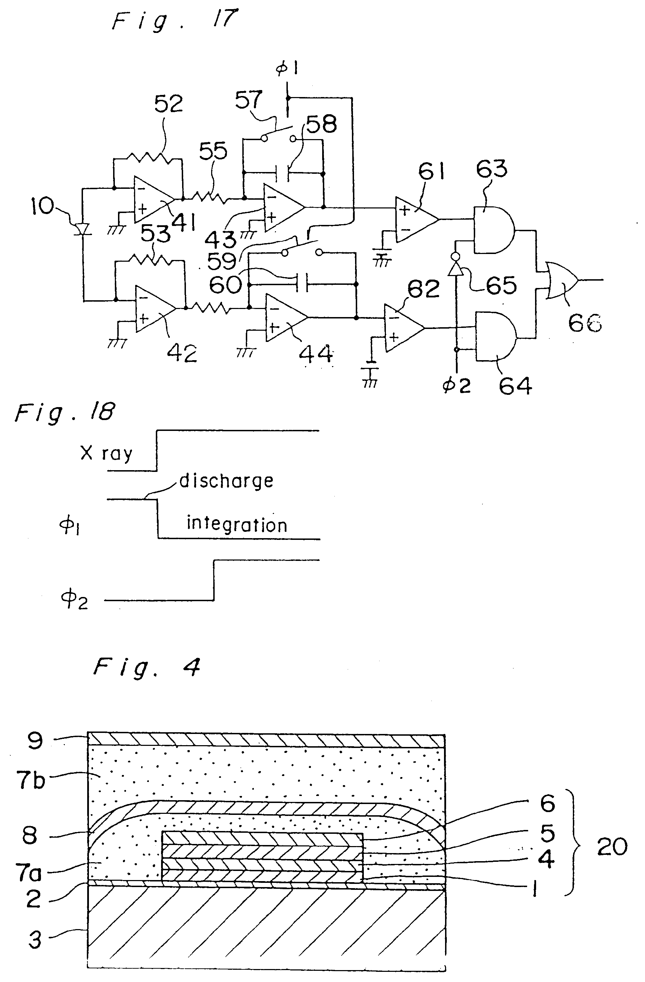

Referring to Fig. 17 showing another example of the X ray detecting circuit in which like parts are designated by like reference numerals and the description of the parts are herein omitted. The output terminals of the amplifiers 43 and 44 are connected to comparators 61 and 62, the outputs of which are connected to respective one input terminals of AND gates 63 and 64. Another input terminal of the AND gate 64 is applied with a signal φ2 and another input terminal of the AND gate 63 is applied with the reversed φ2 signal through an inverter 65. The switches 15 and 16 are operated by the signal φ1 which is the reversed signal which is generated when the X ray is received. The comparators 61 and 62 are respectively supplied with reference signals E1 and E2 which may be equal each other.

In operation, when the level of the X ray is low, the comparator 61 generates an output and when the reversed signal of the signal φ2 becomes high, X ray detection signal can be obtained through the AND gate 63 and an OR gate 66. On the other hand, when the level of the X ray is high, the comparator 62 generates an output and when the signal φ2 is high, the X ray detection signal can be obtained through the AND gate 64 and the OR gate 66. The switches 57 and 59 are turned on by the signal φ1 respectively when the X ray is absent, the capacitors 58 and 60 are reset.

It is noted that the level of the output signals of the respective series of the amplifiers may be adjusted by the time constant of the integration circuits in case the time constant and/or gain of the amplifier means is different between the two series.

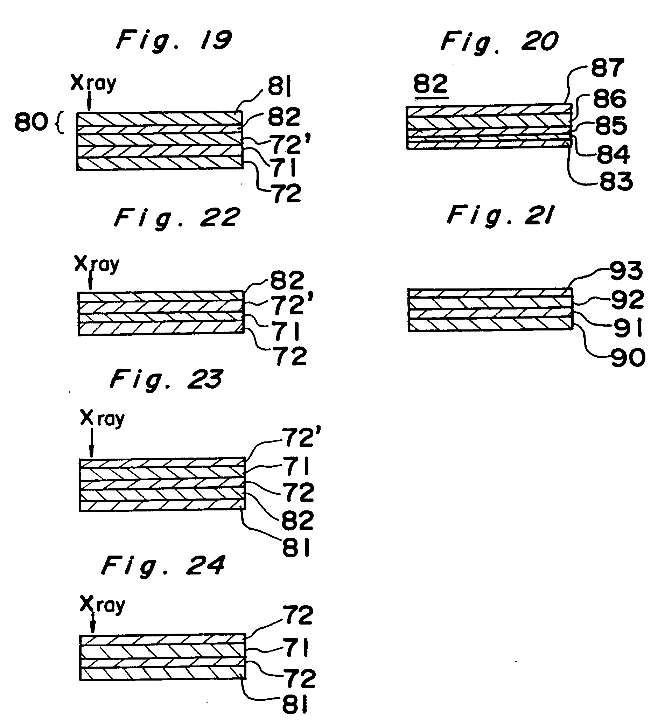

Fig. 19 shows an example of the application of the X ray detecting device according to the present invention, in which a X ray film cassette is integrated with the X ray detecting device in one body.

Referring to Fig. 19, 71 denotes a photographic film of a rectangular planner shape which can sense the visible light. The X ray film 71 is sandwiched by a pair of X ray to visible light converting papers 72 and 72′ (referred to as XL converting paper hereinafter). The arrangement of the X ray film 71 and the XL converting papers 72 and 72′ is the same as the X ray film cassette known in the prior art, the detail thereof is herein omitted.

An X ray detecting device 80 according to the present invention is laminated on the top surface of the XL converting paper 72′. As the X ray detecting device, there may be used various devices as shown in the embodiments already mentioned above in the present invention.

However, in the example shown in Fig. 19, the X ray detecting device is composed of a XL converting paper 81 and LE converting unit 82.

As the LE converting unit 82, an amorphous silicon LE converting element is preferably used. The specific structure of the LE converting element unit 82 is shown in Fig. 20, in which on the surface of a glass substrate 83, a TCO layer 84 is formed. An amorphous silicon layer 85 (referred to as a-si pin layer hereinafter) is formed on the TCO layer 84. A metal layer 86 is formed on the a-si pin layer 85 and the metal layer 86 is covered by a protection layer 87. It is desired to shape the LE converting unit 80 corresponding to the shape of the area to be radiographed. For example, in order to measure the intensity of the X ray of the object area such as stomach or cancer, it is desired to provide the LE converting unit only in the area to be detected. When the LE converting unit using the amorphous silicon is used, it is possible to shape the LE converting unit as desired.

The TCO layer 84 is formed using ITO (indium titan oxide) or $SnO_2$ by way of sputtering method, resistance heating deposit method, EB (electron beam) deposit method with 300 to 1,000 angstrom thick.

The a-si pin layer 85 is formed by preferably a parallel plate plasma CVD method with 5,000 to 15,000 angstrom thick. The metal layer 86 is formed using $A\ell$, Ag, Cr, SUS, Cu. Au in a manner similar to the way of making the TCO layer with 500 to 10,000 angstrom thick. The protection layer 87 is formed using plastic synthetic resin such as epoxy resin, phoenor resin by a screen printing, roll coating, brush painting with 1 to 10 μm thick. It is possible to laminate a number of synthetic resin layers.

In the arrangement mentioned above, the LE converting unit is placed in such a manner that the glass 83 faces with the XL converting paper 81 and the arrangement mentioned above is put on the XL converting paper 72′. In the X ray detecting device mentioned above, when the X ray comes into the X ray detecting device from above, the X ray reaches the XL converting paper 81 and the fluorescent contained in the XL converting paper 81 is excited by the X ray and generates visible light, which radiates the LE converting unit 80, so that an electric output corresponding to the intensity of the X ray can be generated from the LE converting unit 80. The X ray passes the LE converting unit 80 reaches the XL converting papers 72 and 72′ through the film 71. The X ray is converted into visible light by the XL converting papers 72 and 72′ and the light thus converted is radiated to the photographic film which senses the visible light. Thus, the X ray image of the object can be photographed by the film 71.

The LE converting unit 80 may be formed in such a manner that a metal layer 91 made of $A\ell$ or Cr is formed on a film layer 90 and a-si pin layer 92 is formed on the metal layer 91 further a TCO layer 93 is formed on the a-sin pin layer 92. In this arrangement, the film layer 90 is laid on the XL converting paper 72′ of the device shown in Fig. 19.

Fig. 22 shows a modification of the device shown in Fig. 19, wherein the top and bottom of the LE converting unit 80 shown in Fig. 20 is reversed and put on the XL converting paper 72′ eliminating the XL converting paper 81. In this case, the XL converting paper 72′ must radiate the visible light on both surfaces.

In case the absorption of the X ray in the LE converting unit 80 is high if glass is used in the LE converting unit, the X ray is attenuated when the X ray reaches the object to be radiographed. In order to prevent this drawback, it is desired to dispose the X ray detecting device at the side after the X ray passes the photographic film. Figs. 23 and 24 show the examples for this purpose. By the arrangement shown in Figs. 23 and 24, it is possible to prevent such a drawback that the edge portions of the glass plate used in the LE converting unit appear in the picture of the radiograph.

It is noted that in Figs. 19 to 24, X ray film cassette, cushioning members for resiliently supporting the photographic film and a lid plate for interrupting the X ray are omitted but they are used in a manner similar to the known manner.

## Claims

1. An X-ray detecting device for placement between an X-ray source and a radiographic recording means, and which comprises:

XL-converting means (8) for receiving and transmitting X-rays and radiating visible light, the intensity of which light corresponds to the intensity of the received X-rays; and

LE-converting means (10:20) for receiving the light generated from said XL-converting means (8) and generating an electrical signal corresponding to the intensity of the visible light, said LE-converting means comprising electrode means (4, 6) for deriving the electric signal and a base layer (1);

characterized in that

said LE-converting means (10:20) further comprises an amorphous semiconductor photo electric converting layer (5), and

said base layer (1) is made of polyimide film having a thickness of 25 µm to 150 µm so that no image of the X-ray detecting device is produced on the radiographic recording means placed to receive the X-rays.

2. The X-ray detecting device according to claim 1, characterized in that the LE-converting means (10:20) and the XL converting means (8) are arranged one on the other on an underlying base plate (3), said base plate (3) being made of a composite material of carbon fibers and epoxy resin and having a small enough thickness so that no image of the X-ray detecting device is produced on the radiographic recording means placed to receive the X-rays.

3. The X-ray detecting device according to claim 2 wherein the base plate (3) has an Aluminium equivalent smaller than 1 mm and preferably smaller than 0.5 mm.

4. The X-ray device according to claim 2 or 3, characterized in that the thickness of said base plate (3) is 0.4 mm.

5. The X-ray detecting device according to claim 1, characterized in that said device further comprises conductor means (4b, 6b) formed on said base layer (1) extending from said electrode means (4, 6) to an area to be photographed, said conductor means (4b, 6b) being made thin for allowing the passage of X-rays.

6. The X-ray detecting device according to claim 2, further characterized by Tedler film (9) that is a flourine-containing resin film which includes Al and one sealing film (7b) made of a light permeable and moisture proof adhesive.

7. The X-ray detecting device according to claim 5, characterized in that said conductor means (4b, 6b) is 50 to 1000 µm (500 to 10,000 Angstrom) thick.

8. The X-ray detecting device according to claim 1 or 2, characterized in that said LE-converting means (10:20) is smaller than the area to be photographed.

9. The X-ray detecting device according to claim 6, characterized in that said sealing film (7b) is made of polyvinylbutyral or ethylenevinylacetate.

10. The X-ray detecting device according to claim 1 or 2 and further characterized by:

two series of amplifier means (41, 42) provided for the respective electrode means (4, 6), each series comprising an integration circuit (43, 44) and

selecting means (61) for selecting any one of series of said amplifier means (41, 42) corresponding to the range of the intensity of the X-ray to be detected.

11. The X-ray detecting device according to claim 10, characterized in that the level of the output signals of the respective series of the amplifier means (41, 43; 42, 44) is adjusted by the time constant of the integration circuits (43, 44) in case the time constant and/or gain of the amplifier means (41, 42) is different between the two series.

12. The X-ray detecting device according to claim 10, characterized in that said selecting means (61) is the output of the amplifier means (41, 42).

13. The X-ray detecting device according to claim 9, characterized in that said selecting means (61) is the output of the integration circuit (43, 44) which respectively integrates the signals in the respective series of the amplifier means (41, 42).

14. An X-ray detecting device according to any of the claims 1 to 10, further characterized by capacitor means (31) connected with said semiconductor layer or stray capacitor (33) of the semiconductor layer for stroring the charge occurring across the semiconductor layer, so that the output of the X-ray converting device (8) can be generated by the charge stored in said capacitor means (31).

15. The X-ray detecting device according to claim 14, characterized in that said device further comprises amplifying means (35) for amplifying the voltage across the capacitor (31) or stray capacitor (33) and switching means (36) for applying the voltage across the capacitor (31) or stray capacitor (33) to said amplifying means (35).

**16.** The X-ray detecting device according to claim 14, characterized in that said device further comprises a current voltage amplifier (35) to amplify the current of the capacitor (31) or stray capacitor (33) for outputting a voltage signal representing the intensity of the X-rays.

**17.** The X-ray detecting device according to claim 2 or any dependent claim thereof, characterized in that Al equivalent of said base plate (3) is smaller than 0.5 mm.

**18.** A film cassette including a photographic film (71) and an X-ray detecting device according to any of claims 1 to 17.

**19.** The film cassette according to claim 18, characterized in that said XL-converting means act as XL-converting means for projecting the light corresponding to the X-ray to the photographic film.

**20.** The film cassette according to claim 18, characterized in that said X-ray detecting device is disposed at the side where the X-ray has passed the photographic film (71).

**21.** A method of X-ray photography or X-ray analysis of an object using an X-ray source and an X-ray detecting device according to any preceding claim, wherein the XL-converting means (8) is larger than the irradiated target area of the object and the LE-converting means (10:20) is smaller than said irradiated target area.

**22.** A method of X-ray photography and/or X-ray analysis of an object using an X-ray source and an X-ray detecting device according to anyone of claims 1 to 17, comprising the steps of:
measuring the intensity of the X-ray generated by said X-ray source in said X-ray detecting device; and
using the X-ray passed through said X-ray detecting device.

**Patentansprüche**

**1.** Röntgenstrahl-Erfassungseinrichtung zur Anordnung zwischen einer Röntgenstrahlquelle und einer radiographischen Aufzeichnungseinrichtung, umfassend:
eine XL-Umwandlungseinrichtung (8) zum Empfangen und Transmittieren von Röntgenstrahlen und zum Ausstrahlen von sichtbarem Licht, wobei die Intensität des Lichts der Intensität der empfangenen Röntgenstrahlen entspricht; und
eine LE-Umwandlungseinrichtung (10:20) zum Empfangen des von der XL-Umwandlungseinrichtung (8) erzeugten Lichts und zum Erzeugen eines elektrischen Signals entsprechend der Intensität des sichtbaren Lichts, wobei die LE-Umwandlungseinrichtung eine Elektrodeneinrichtung (4, 6) zum Ableiten des elektrischen Signals und eine Basisschicht (1) umfaßt;
dadurch **gekennzeichnet,** daß
die LE-Umwandlungseinrichtung (10:20) ferner eine amorphe photoelektrische Halbleiter-Umwandlungsschicht (5) umfaßt; und
die Basisschicht (1) aus einem Polyimidfilm mit einer Dicke von 25 µm bis 150 µm hergestellt ist, so daß kein Bild der Röntgenstrahl-Erfassungseinrichtung auf der radiographischen Aufzeichnungseinrichtung erzeugt wird, die zum Empfang der Röntgenstrahlen angeordnet ist.

**2.** Röntgenstrahl-Erfassungseinrichtung nach Anspruch 1, dadurch gekennzeichnet, daß die LE-Umwandlungseinrichtung (10:20) und die XL-Umwandlungseinrichtung (8) aufeinander auf einer darunterliegenden Basisplatte (3) angeordnet sind, wobei die Basisplatte (3) aus einem zusammengesetzten Material aus Kohlenstoffasern und Epoxydharz hergestellt ist und eine ausreichend kleine Dicke aufweist, so daß kein Abbild der Röntgenstrahl-Erfassungseinrichtung auf der radiographischen Aufzeichnungseinrichtung erzeugt wird, die zum Empfang der Röntgenstrahlen angeordnet ist.

**3.** Röntgenstrahl-Erfassungseinrichtung nach Anspruch 2, dadurch gekennzeichnet, daß die Basisplatte (3) ein Aluminium-Äquivalent kleiner als 1 mm und vorzugsweise kleiner als 0,5 mm aufweist.

**4.** Röntgenstrahleinrichtung nch Anspruch 2 oder 3, dadurch gekennzeichnet, daß die Dicke der Basisplatte (3) 0,4 mm beträgt.

**5.** Röntgenstahl-Erfassungseinrichtung nach Anspruch 1, dadurch gekennzeichnet, daß die Einrichtung ferner eine auf der Basisschicht (1) gebildete Leitereinrichtung (4b, 6b) umfaßt, die sich von der Elektrodeneinrichtung (4, 6) an einen zu fotografierenden Bereich erstreckt, wobei die Leitereinrichtung (4b, 6b) dünn ausgeführt ist, um das Durchtreten von Röntgenstrahlen zu ermöglichen.

**6.** Röntgenstrahl-Erfassungseinrichtung nach Anspruch 2, ferner gekennzeichnet durch einen Tedler-Film (9), der ein ein Fluoreszenzmittel enthaltender Harzfilm ist, der Al umfaßt und einen Abdichtungsfilm (7b), hergestellt aus einem lichtdurchlässigen und feuchtigkeitsundurchlässigen Haftungsmittel.

7. Röntgesntrahl-Erfassungseinrichtung nach Anspruch 5, dadurch gekennzeichnet, daß die Leitereinrichtung (4b, 6b) eine Dicke von 50 bis 1000 μm (500 bis 10.000 Å) aufweist.

8. Röntgenstrahl-Erfassungseinrichtung nach Anspruch 1 oder 2, dadurch gekennzeichnet, daß die LE-Umwandlungseinrichtung (10:20) kleiner als die zu fotografierende Fläche ist.

9. Röntgenstrahl-Erfassungseinrichtung nach Anspruch 6, dadurch gekennzeichnet, daß der Abdichtungsfilm (7b) aus Polyvinylbutyral oder Äthylenvinylacetat hergestellt ist.

10. Röntgenstrahl-Erfassungseinrichtung nach Anspruch 1 oder 2, und ferner gekennzeichnet durch:
zwei Reihen von Verstärkereinrichtungen (41, 42), die für die jeweilige Elektrodeneinrichtung (4, 6) vorgesehen sind, wobei jede Reihe eine Integrationsschaltung (43, 44) umfaßt, und
eine Wähleinrichtung (61) zum Wählen einer Reihe der Verstärkereinrichtungen (41, 42) entsprechend dem Bereich der Intensität des zu detektierenden Röntgenstrahls.

11. Röntgenstrahl-Erfassungseinrichtung nach Anspruch 10, dadurch gekennzeichnet, daß der Pegel der Ausgangssignale der jeweiligen Reihen der Verstärkereinrichtungen (41, 43; 42, 44) durch die Zeitkonstante der Integrationsschaltungen (43, 44) eingestellt wird, für den Fall, daß die Zeitkonstante und/oder Verstärkung der Verstärkungseinrichtung (41, 42) zwischen den beiden Reihen unterschiedlich ist.

12. Röntgenstrahl-Erfassungseinrichtung nach Anspruch 10, dadurch gekennzeichnet, daß die Wähleinrichtung (61) der Ausgang der Verstärkungseinrichtung (41, 42) ist.

13. Röntgenstrahl-Erfassungseinrichtung nach Anspruch 9, dadurch gekennzeichnet, daß die Wähleinrichtung (61) der Ausgang der Integrationsschaltung (43, 44) ist, die jeweils die Signale in den jeweiligen Reihen der Verstärkereinrichtungen (41, 42) integriert.

14. Röntgenstrahl-Erfassungseinrichtung nach einem der Ansprüche 1 bis 10, ferner gekennzeichnet durch eine mit der Halbleiterschicht verbundene Kondensatoreinrichtung (31) oder einen Streukondensator (33) der Halbleiterschicht zum Speichern der Ladung, die über der Halbleiterschicht auftritt, so daß der Ausgang der Röntgenstrahl-Umwandlungseinrichtung (8) durch die in der Kondensatoreinrichtung (31) gespeicherten Ladung erzeugt werden kann.

15. Röntgenstrahl-Erfassungseinrichtung nach Anspruch 14, dadurch gekennzeichnet, daß die Einrichtung ferner eine Verstärkungseinrichtung (35) zum Verstärken der Spannung über dem Kondensator (31) oder dem Streukondensator (33) und eine Umschalteinrichtung (36) zum Anlegen der Spannung über dem Kondensator (31) oder dem Streukondensator (33) an die Verstärkungseinrichtung (35) umfaßt.

16. Röntgenstrahl-Erfassungseinrichtung nach Anspruch 14, dadurch gekennzeichnet, daß die Einrichtung ferner einen Strom-Spannungs-Verstärker (35) umfaßt, um den Strom des Kondensators (31) oder des Streukondensators (33) zu verstärken, zum Ausgeben eines Spannungssignals, das die Intensität der Röntgenstrahlen darstellt.

17. Röntgenstrahl-Erfassungseinrichtung nach Anspruch 2 oder irgendeinem abhängigen Anspruch davon, dadurch gekennzeichnet, daß ein Al-Äquivalent der Basisplatte (3) kleiner als 0,5 mm ist.

18. Filmkassette, umfassend einen fotografischen Film (71) und eine Röntgenstrahl-Erfassungseinrichtung nach einem der Ansprüche 1 bis 17.

19. Filmkassette nach Anspruch 18, dadurch gekennzeichnet, daß die XL-Umwandlungseinrichtung als eine XL-Umwandlungseinrichtung zum Projizieren des Lichts entsprechend dem Röntgenstrahl auf den fotografischen Film wirkt.

20. Filmkassette nach Anspruch 18, dadurch gekennzeichnet, daß sich die Röntgenstrahl-Erfassungseinrichtung an der Seite befindet, an der der Röntgenstrahl durch den fotografischen Film (71) gelaufen ist.

21. Verfahren zur Röntgenstrahlfotografie oder Röntgenstrahlanalyse eines Objekts unter Verwendung einer Röntgenstrahlquelle und einer Röntgenstrahl-Erfassungseinrichtung nach irgendeinem der vorangehenden Ansprüche, wobei die XL-Umwandlungseinrichtung (8) größer als die bestrahlte Zielfläche des Objekts ist und die LE-Umwandlungseinrichtung (10:20) kleiner als die bestrahlte Zielfläche ist.

22. Verfahren zur Röntgenstrahlfotografie und/oder Röntgenstrahlanalyse eines Objekts unter Verwendung einer Röntgenstrahlquelle und einer Röntgenstrahl-Erfassungseinrichtung nach einem der Ansprüche 1 bis 17, umfassend die folgenden Schritte:

Messen der Intensität des durch die Röntgenstrahlquelle erzeugten Röntgenstrahls in der Röntgenstrahl-Erfassungseinrichtung; und Verwenden des durch die Röntgenstrahl-Erfassungseinrichtung getretenen Röntgenstrahls.

## Revendications

1. Dispositif de détection de rayons X à installer entre une source de rayons X et un moyen d'enregistrement radiographique, et comprenant:

   un moyen de conversion XL (8) pour recevoir et émettre des rayons X et irradier une lumière visible, lumière dont l'intensité correspond à l'intensité des rayons X reçus; et

   un moyen de conversion LE (10:20) pour recevoir la lumière produite par ledit moyen de conversion XL (8) et produire un signal électrique correspondant à l'intensité de la lumière visible, ledit moyen de conversion LE comprenant des moyens formant électrodes (4, 6) pour extraire le signal électrique et une couche de base (1);

   caractérisé en ce que

   ledit moyen de conversion LE (10:20) comprend en outre une couche (5) de conversion photo-électrique en semi-conducteur amorphe, et

   ladite couche de base (1) est constituée par une pellicule de polymide de 25 μm à 150 μm d'épaisseur de façon qu'aucune image du dispositif de détection de rayons X ne soit produite sur le moyen d'enregistrement radiographique placé pour recevoir les rayons X.

2. Dispositif de détection de rayons X selon la revendication 1, caractérisé en ce que le moyen de conversion LE (10:20) et le moyen de conversion XL (8) sont superposés sur une plaque de montage sous-jacente (3), ladite plaque de montage (3) étant en matière composite constituée de fibres de carbone et de résine époxy et ayant une épaisseur suffisamment faible pour qu'aucune image du dispositif de détection de rayons X ne soit produite sur le moyen d'enregistrement radiographique placé pour recevoir les rayons X.

3. Dispositif de détection de rayons X selon la revendication 2, dans lequel la plaque de montage (3) a un équivalent aluminium inférieur à 1 mm et, de préférence, inférieur à 0,5 mm.

4. Dispositif de détection de rayons X selon la revendication 2 ou 3, caractérisé en ce que l'épaisseur de ladite plaque de montage (3) est de 0,4 mm.

5. Dispositif de détection de rayons X selon la revendication 1, caractérisé en ce que ledit dispositif comporte en outre des moyens formant conducteurs (4b, 6b) formés sur ladite couche de montage (1) s'étendant depuis lesdits moyens formant électrodes (4, 6) jusqu'à une zone à radiographier, lesdits moyens formant conducteurs (4b, 6b) étant réalisés avec une faible épaisseur pour permettre le passage de rayons X.

6. Dispositif de détection de rayons X selon la revendication 2, caractérisé en outre par un film de Tedler (9) qui est une pellicule de résine fluorée contenant Al et un film d'étanchéité (7b) en adhésif perméable à la lumière et imperméable à l'humidité.

7. Dispositif de détection de rayons X selon la revendication 5, caractérisé en ce que lesdits moyens formant conducteurs (4b, 6b) ont une épaisseur de 50 à 1000 μm (500 à 10 000 angströms).

8. Dispositif de détection de rayons X selon la revendication 1 ou 2, caractérisé en ce que ledit moyen de conversion LE (10:20) est plus petit que la zone à radiographier.

9. Dispositif de détection de rayons X selon la revendication 6, caractérisé en ce que ledit film d'étanchéité (7b) est en polybutyral de vinyle ou en éthylène-acétate de vinyle.

10. Dispositif de détection de rayons X selon la revendication 1 ou 2, caractérisé en outre par:

    deux séries de moyens formant amplificateurs (41, 42) prévues pour les moyens formant électrodes respectifs (4, 6), chaque série comportant un circuit d'intégration (43,44) et

    un moyen de sélection (61) pour sélectionner l'une quelconque des séries desdits moyens formant amplificateurs (41, 42) correspondant à la plage d'intensité des rayons X à détecter.

11. Dispositif de détection de rayons X selon la revendication 10, caractérisé en ce que le niveau des signaux de sortie des séries respectives des moyens formant amplificateurs (41, 43; 42, 44) est réglé par la constante de temps des circuits d'intégration (43, 44) dans le cas où la constante de temps et/ou le gain des moyens formant amplificateurs (41, 42) est différent d'une série à l'autre.

12. Dispositif de détection de rayons X selon la revendication 10, caractérisé en ce que ledit moyen de sélection (61) est la sortie des moyens formant amplificateurs (41, 42).

**13.** Dispositif de détection de rayons X selon la revendication 9, caractérisé en ce que ledit moyen de sélection (61) est la sortie du circuit d'intégration (43, 44) qui intègre respectivement les signaux des séries respectives des moyens formant amplificateurs (41, 42).

**14.** Dispositif de détection de rayons X selon l'une quelconque des revendications 1 à 10, caractérisé en outre par un moyen formant condensateur (31) connecté à ladite couche de semiconducteur ou par un condensateur de fuite (33) de la couche de semiconducteur pour stocker la charge apparaissant dans la couche de semiconducteur, de façon que le signal de sortie du dispositif (8) de conversion de rayons X puisse être généré par la charge stockée dans ledit moyen formant condensateur (31).

**15.** Dispositif de détection de rayons X selon la revendication 14, caractérisé en ce que ledit dispositif comporte en outre un moyen d'amplification (35) pour amplifier la tension dans le condensateur (31) ou le condensateur de fuite (33) et un moyen de commutation (36) pour appliquer audit moyen d'amplification (35) la tension existant dans le condensateur (31) ou dans le condensateur de fuite (33).

**16.** Dispositif de détection de rayons X selon la revendication 14, caractérisé en ce que ledit dispositif comporte en outre un amplificateur (35) courant-tension pour amplifier le courant du condensateur (31) ou du condensateur de fuite (33) afin de produire un signal de tension représentant l'intensité des rayons X.

**17.** Dispositif de détection de rayons X selon la revendication 2 ou l'une quelconque des revendications rattachées à celle-ci, caractérisé en ce que l'équivalent Al de ladite plaque de montage (3) est inférieur à 0,5 mm.

**18.** Cassette de film comportant un film photographique (71) et un dispositif de détection de rayons X selon l'une quelconque des revendications 1 à 17.

**19.** Cassette de film selon la revendication 18, caractérisée en ce que ledit moyen de conversion XL sert de moyen de conversion XL pour projeter sur le film photographique la lumière correspondant aux rayons X.

**20.** Cassette de film selon la revendication 18, caractérisée en ce que ledit dispositif de détection de rayons X est disposé du côté où les rayons X ont dépassé le film photographique (71).

**21.** Procédé de radiographie ou d'analyse par rayons X d'un objet à l'aide d'une source de rayons X et d'un dispositif de détection de rayons X selon l'une quelconque des revendications précédentes, dans lequel le moyen de conversion XL (8) est plus grand que la zone cible irradiée de l'objet et le moyen de conversion LE (10:20) est plus petit que ladite zone cible irradiée.

**22.** Procédé de radiographie et/ou d'analyse par rayons X d'un objet à l'aide d'une source de rayons X et d'un dispositif de détection de rayons X selon l'une quelconque des revendications 1 à 17, comprenant les étapes consistant à:
mesurer l'intensité des rayons X produits par ladite source de rayons X dans ledit dispositif de détection de rayons X; et
utiliser les rayons X amenés à passer à travers ledit dispositif de détection de rayons X.

*Fig. 1*

*Fig. 2*

*Fig. 3*

Fig. 5

Fig. 6

Fig. 7

Fig. 8

Fig. 9

light

10

33

34

32

31

+

−

35

Fig. 10

10

6'

5

4

8'

3

Fig. 11

output of amplifier 35.

90mv

0                    500 msec

SW 32 ON                time.

# Fig. 12

# Fig. 13

# Fig. 14

# Fig. 15

# Fig. 16

Fig. 17

Fig. 18

Fig. 4

Fig. 19

Fig. 20

Fig. 22

Fig. 21

Fig. 23

Fig. 24